# FASCICULE DE BREVET EUROPEEN

(11) **EP 1 023 608 B1**
(45) Date de publication et mention de la délivrance du brevet: **19.09.2001**
(21) Numéro de dépôt: 98917275.4
(22) Date de dépôt: 31.03.1998
(51) Int. Cl.: G01R 33/09, G11B 5/39

(54) **CAPTEUR DE CHAMP MAGNETIQUE A MAGNETORESISTANCE**
MAGNETFELDFÜHLER MIT MAGNETOWIDERSTAND
MAGNETIC FIELD SENSOR WITH MAGNETORESISTOR

(30) Priorité: 01.04.1997 FR 9703943
(43) Date de publication de la demande: 02.08.2000
(73) Titulaire: COMMISSARIAT A L'ENERGIE ATOMIQUE, 75015 Paris (FR)
(72) Inventeur: ALBERTINI, Jean-Baptiste, F-38100 Grenoble (FR); AID, Marc, F-38000 Grenoble (FR)
(74) Mandataire: Signore, Robert
(86) Numéro de dépôt international: FR9800648
(87) Numéro de publication internationale: WO9844359

(56) Documents cités:
- EP-A- 0 331 135
- EP-A- 0 501 603
- US-A- 4 291 351
- US-A- 5 436 779
- US-A- 5 583 726

## Description

### Domaine technique

La présente invention a pour objet un capteur de champ magnétique à magnétorésistance. Elle trouve une application principalement dans la mesure des champs faibles, allant du nanotesla à quelques millitesias et dans l'enregistrement magnétique en particulier pour la lecture.

### Etat de la technique antérieure

Un capteur de champ magnétique à magnétorésistance est un dispositif comprenant, schématiquement, un circuit magnétique avec un entrefer principal apte à capter le champ à mesurer, et un entrefer secondaire (ou de lecture) associé à une magnétorésistance. (Dans certains cas, l'entrefer principal et l'entrefer secondaire sont confondus). Le champ magnétique capté est canalisé par le circuit magnétique et se trouve couplé dans l'entrefer secondaire a la magnétorésistance. Cette dernière voit sa résistance dépendre du champ qui la traverse, de sorte que la mesure de cette résistance permet d'accéder au champ magnétique capté.

De tels capteurs peuvent prendre des formes diverses et notamment se présenter comme des têtes magnétiques à couches minces, travaillant aussi bien en lecture qu'en écriture. Dans une tête magnétique à couches minces, le circuit magnétique est constitué d'une ou de plusieurs couches de faible épaisseur (typiquement de l'ordre du micron) en matériau à forte perméabilité. Une tête magnétique en couches minces peut présenter une structure horizontale, lorsque le plan des couches minces est, en fonctionnement, parallèle au support d'enregistrement (disque ou bande), ou une structure perpendiculaire, lorsque ce plan est perpendiculaire au support d'enregistrement. Pour chacun de ces deux types de têtes, on peut concevoir un fonctionnement de type inductif à l'écriture, par passage d'un courant dans un bobinage conducteur entourant le circuit magnétique.

La magnétorésistance, qui sert à la lecture, sera notée MR par la suite, selon une abréviation habituelle dans cette technique.

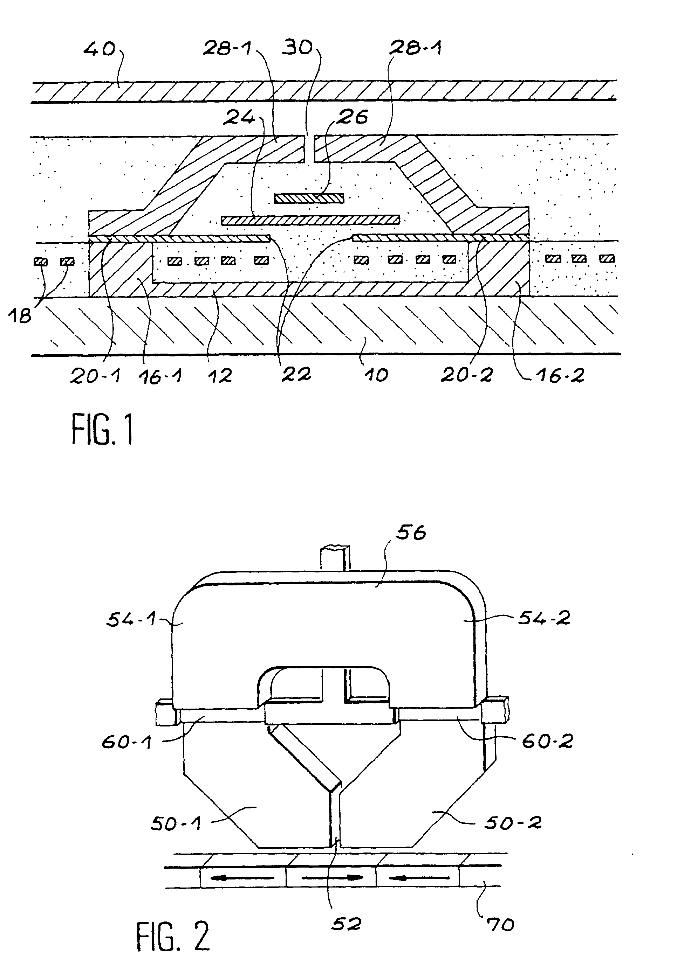

La figure 1 annexée montre un exemple de tête magnétique à couches minces de type horizontal telle que décrite dans le document FR-A-2 712 420. Sur cette figure on voit un substrat 10, une couche magnétique arrière 12, deux piliers magnétiques 16-1, 16-2, deux couches magnétiques intermédiaires 20-1, 20-2 définissant un entrefer secondaire 22, ces couches 20-1, 20-2 étant plus étroites vers l'entrefer 22 que vers les piliers 16-1, 16-2 et réalisant donc des concentrateurs de champ. Une magnétorésistance 24 est disposée en travers de l'entrefer secondaire 22, un conducteur de polarisation 26 étant placé au-dessus d'elle. Deux pièces polaires 28-1, 28-2 définissent un entrefer principal 30. Un bobinage conducteur 18 entoure les piliers 16-1, 16-2. Cette tête est apte à se déplacer relativement par rapport a un support d'enregistrement magnétique 40.

Le document FR-A-2 712 420 contient des références à d'autres têtes magnétiques à couches minces de type horizontal, où la MR est placée au voisinage de l'entrefer principal ou au voisinage d'un entrefer ménagé dans la couche magnétique arrière.

Par ailleurs, l'article de K. YAMADA, intitulé "Magnetoresistive Head for High Density Magnetic Recording" publié dans la revue "IEEE Translation Journal on Magnetics in Japan", vol. 8, n° 4, April 1993, pp. 260-268 décrit une tète magnétique de type vertical, qui est illustrée sur la figure 2 annexée. On y voit une tête comprenant un circuit magnétique avec deux pièces polaires 50-1, 50-2 séparées par un entrefer principal 52, deux branches laterales 54-1, 54-2 et une partie arrière 56 de fermeture. Deux entrefers secondaires sont pratiqués dans les branches latérales où deux MR 60-1, 60-2 y sont disposées.

Le support d'enregistrement 70 est placé en regard de la tête, laquelle est perpendiculaire audit support.

A côté de ces capteurs en forme de tête magnetique d'écriture/lecture, on trouve des capteurs plus simples composés d'une MR disposée entre deux ecrans magnétiques. Le circuit magnétique se trouve donc réduit à ces deux écrans.

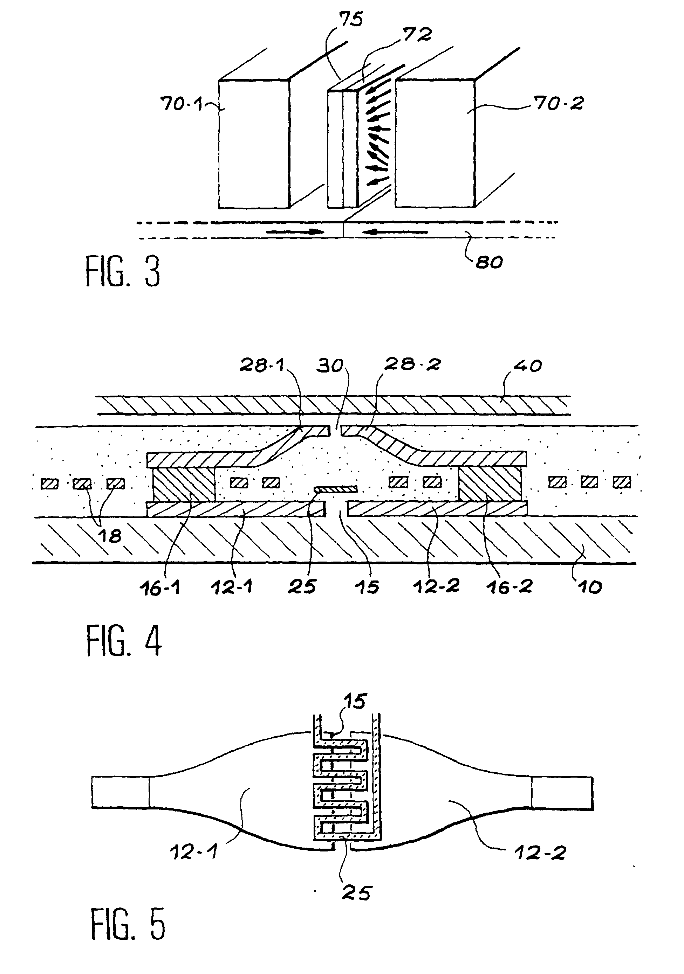

L'article de HIROTSUGU FUKUOKA et al. intitulé "Effect of Magnetic Saturation on Reproducing Characteristics of Magnetoresistive Heads" publié dans la revue "IEEE Transactions on Magnetics", vol. 30, n° 4, Juillet 1994, pp. 1345-1349, décrit ainsi un capteur qui est reproduit sur la figure 3 annexee. Ce capteur comprend deux écrans magnétiques 70-1, 70-2 et une magnetorésistance 72. Un conducteur 75 est plaqué sur cette magnetorésistance. L'ensemble se déplace devant un support d'enregistrement 80. D'une certaine manière, l'entrefer principal, qui capte le champ provenant du support, se trouve confondu avec l'entrefer secondaire contenant la MR.

L'article de R. YAMADA, déjà cité, décrit, lui aussi, un tel dispositif.

Les capteurs magnétiques dont la MR est dans l'entrefer principal présentent des risques de saturation de la MR, risques encore plus importants avec les têtes magnétiques travaillant aussi bien en écriture qu'en lecture.

En outre, tous ces capteurs de l'art antérieur présentent des inconvénients. Dans les têtes magnétiques telles que celles de la figure 1, il existe des fuites de champ magnétique qui affaiblissent le signal de mesure. Dans celles de la figure 2, ces fuites existent également et, en outre, on dispose de peu de place pour loger la MR. Avec les capteurs de la figure 3, la MR est placée trop près du support d'enregistrement, ce qui entraîne une usure accélérée de celle-ci, sans compter des problèmes de claquage électrique. La taille de la MR est en outre limitée par la taille de l'entrefer, qui est lui-même fonction de la densité d'information enregistrée sur le support.

La présente invention a pour but de remédier à ces inconvénients.

Le document EP-A-0 501 603 décrit une tête magnétique avec deux pièces polaires délimitant un entrefer principal, une magnétorésistance et un guide de flux qui n'appartient pas au circuit magnétique mais constitue un moyen supplémentaire affleurant dans l'entrefer principal.

Le document US-A-5,583,726 décrit une tête magnétique à élément magnétorésistant avec encore un guide de flux et une magnécorésistance disposée à l'extrémité de ce guide.

Le document US-A-5,436,779 décrit un transducteur magnétorésistant avec une pièce magnétique inférieure et une couche magnétique supérieure. Un entrefer secondaire est formé et associé à une magnétorésistance.

### Exposé de l'invention

Selon l'invention, on élargit le circuit magnétique au niveau de l'entrefer secondaire, là où est placée la MR, afin de minimiser les pertes de champ (le flux actif, c'est-à-dire traversant la MR, est maximum), tout en maximisant la place disponible pour disposer la MR (ce qui augmente le signal et le rapport signal sur bruit). Les risques de saturation sont ainsi également réduits du fait de la diminution du champ dû à l'élargissement au niveau de l'entrefer secondaire. Jusque là, l'homme du métier avait tendance à concentrer le champ magnétique dans la MR, et donc à diminuer la section du circuit magnétique servant de guide près de l'entrefer de lecture pour augmenter le flux au niveau du capteur. Cela apparaît clairement sur la figure 1, déjà decrite, où les couches 20-1, 20-2 jouent le rôle de concentrateurs. Ce faisant, il augmentait aussi la réluctance du circuit magnétique et les risques de saturation de la MR. En d'autres termes, l'homme du métier cherchait à augmenter le niveau du champ pour augmenter le signal. L'idée originale de l'invention consiste à augmenter la section d'intégration, en profitant du fait que les MR intègrent le signal dans leur volume. Selon l'invention, on élargit donc le circuit magnétique au niveau de l'entrefer de lecture.

De façon plus précise, la présente invention a pour objet un capteur de champ magnétique comprenant un circuit magnétique avec un entrefer principal apte à être traversé par le champ a capter, ce circuit magnétique étant interrompu par au moins un entrefer secondaire pourvu d'une magnétorésistance, ce capteur étant caractérisé en ce que le circuit magnétique présente une forme évasée de part et d'autre de l'entrefer secondaire.

Le capteur de l'invention peut prendre diverses formes, par exemple soit la forme générale des têtes magnétiques à couches minces de type horizontal, soit celle des têtes magnétiques à couche mince de type vertical, soit encore la forme des capteurs à écrans magnétiques.

### Brève description des figures

- La figure 1, déjà décrite, montre une tête magnétique à couches minces horizontale selon l'état de la technique,
- la figure 2, déjà décrite, montre une tête magnétique verticale selon l'état de la technique,
- la figure 3, déjà décrite, montre un capteur constitué d'une magnétorésistance encadrée par deux écrans, selon l'état de la technique,
- la figure 4 illustre un premier mode de réalisation de l'invention correspondant à une tête magnétique en couches minces de type horizontale, vue en coupe,

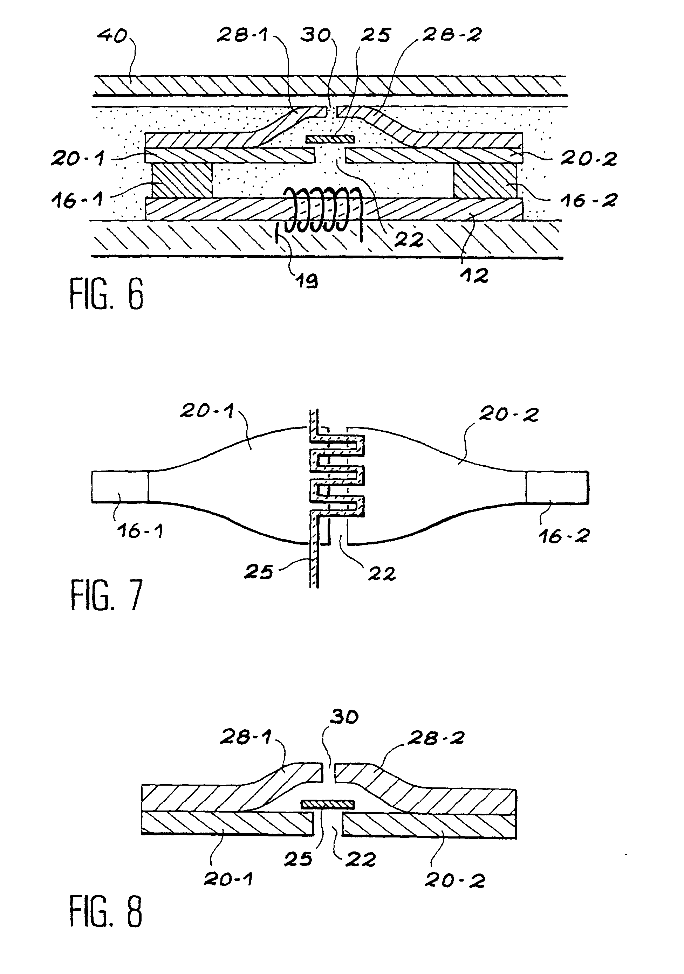

- la figure 5 montre, en vue de dessus, l'élargissement du circuit magnétique au niveau de l'entrefer secondaire,
- la figure 6 montre, en coupe, une variante de tête magnétique à couches minces horizontale à couches magnétiques intermédiaires évasées,
- la figure 7 montre, en vue de dessus, les couches magnétiques intermédiaires évasées,

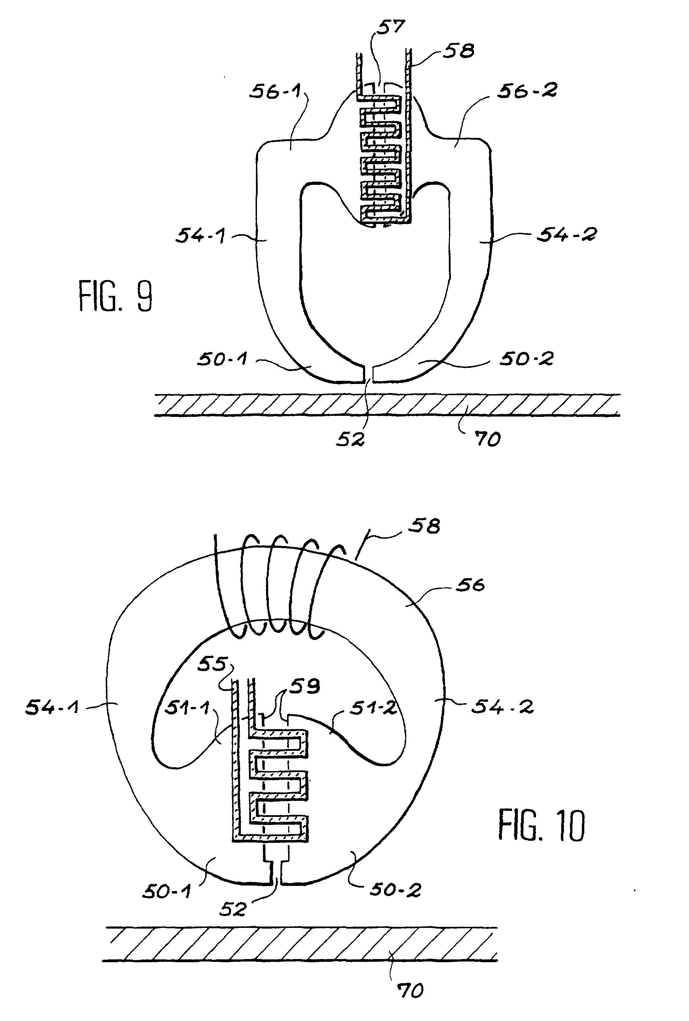

- la figure 8 montre une autre variante simple, en coupe,
- la figure 9 illustre un deuxième mode de réalisation correspondant à une tête magnétique verticale,
- la figure 10 montre une variante de tête magnétique verticale à entrefer secondaire situé juste derrière l'entrefer principal,

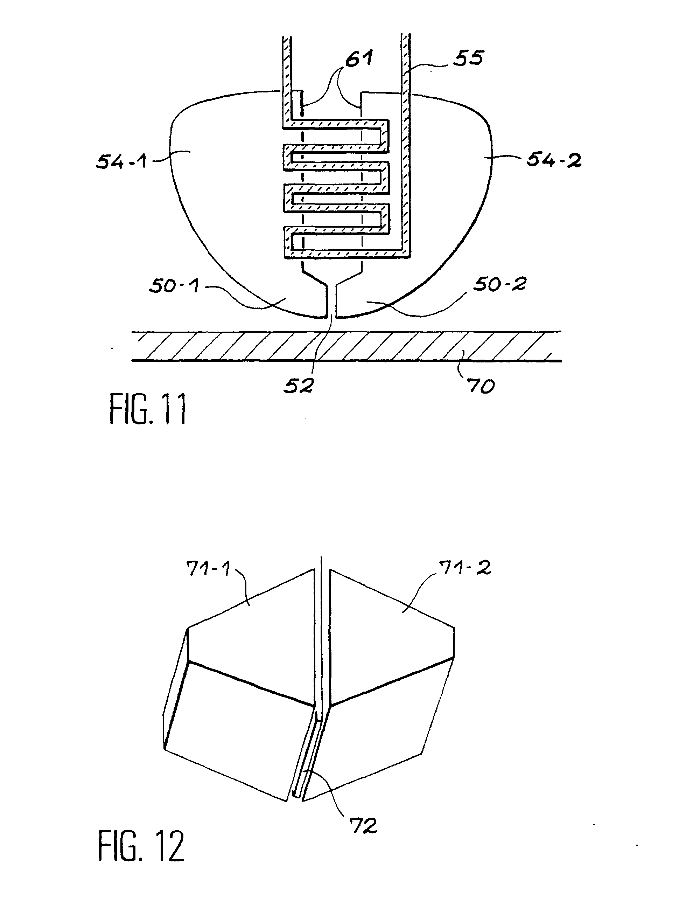

- la figure 11 montre une autre variante simplifiée,
- la figure 12 montre une autre variante à écrans magnétiques.

### Description détaillée de modes de réalisation

Selon un premier mode de réalisation, illustré par les figures 4 à 8, le capteur se présente sous la forme générale d'une tête magnétique à couches minces horizontale. Sur la figure 4, tout d'abord, on voit un capteur comprenant, comme pour la tête illustrée sur la figure 1, un substrat 10, une couche magnétique arrière, deux piliers magnétiques 16-1, 16-2, une couche magnétique avant avec deux pièces polaires 28-1, 28-2 séparées par un entrefer principal 30. La tête se déplace devant un support d'enregistrement 40 parallèle au plan des couches.

L'originalité du capteur représenté sur la figure 4 tient à ce que les couches magnétiques 12-1 et 12-2 encadrant l'entrefer secondaire 15 et sa magnétorésistance 25, présentent une forme évasée, comme on le voit mieux sur la figure 5. Sur cette dernière figure, par souci de simplification, ne sont représentées que les pièces 12-1 et 12-2, l'entrefer secondaire 15 et la MR associée 25.

La figure 6 montre une autre variante où la tête comprend deux couches magnétiques intermédiaires 20-1, 20-2 disposées entre les pièces polaires 28-1, 28-2 et la couche magnétique arrière 12, ces couches intermédiaires définissant l'entrefer secondaire 22 pourvu de la MR 25. La forme évasée des couches 20-1, 20-2 apparaît mieux sur la figure 7 qui est une vue de dessus.

Dans cette variante, il est possible d'enrouler, autour de la couche arrière 12, un bobinage conducteur 19 ou de réaliser un bobinage intégré de type solénoide. Mais on pourrait aussi bien disposer ce bobinage autour des piliers magnétiques 16-1, 16-2, comme pour la tête de la figure 1.

Un capteur très simple est représenté sur la figure 8, où il n'y a plus qu'une couche magnétique avant avec ses deux pièces polaires 28-1, 28-2 séparees par l'entrefer principal 30 et une couche magnétique arrière formée par les deux parties évasées 20-1, 20-2 séparées par l'entrefer secondaire 22. Les parties evasées 20-1 et 20-2 de la fiqure 8 peuvent avoir la forme représentée sur la figure 7.

Selon un second mode de réalisation, illustré par les figures 9, 10 et 11, le capteur se présente sous la forme générale d'une tête magnétique verticale. Sur la figure 9, tout d'abord, on voit un capteur comprenant deux pièces polaires 50-1, 50-2 encadrant un entrefer principal 52, deux branches latérales 54-1, 54-2 pouvant être éventuellement entourées d'un bobinage de type solénoide, et une branche arrière constituée par deux parties 56-1, 56-2 évasées de part et d'autre d'un entrefer secondaire 57. La magnétorésistance 58 est couplée à cet entrefer. Toutes les pièces magnétiques peuvent être obtenues par dépôt et gravure d'une couche magnétique dont le plan est perpendiculaire au support d'enregistrement 70.

Selon une variante de ce mode de réalisation, l'entrefer secondaire est réalisée dans au moins une des branches latérales, la MR étant couplée à cet entrefer. Dans le cas où chaque branche latérale comporte un entrefer secondaire, une MR est alors associée à chacun de ces entrefers.

Dans la variante illustrée par la figure 10, la branche arrière 56 est d'une seule pièce et ce sont les branches latérales qui se prolongent par deux parties évasées 51-1, 51-2 définissant l'entrefer secondaire 59. Ce dernier est donc placé Juste derrière l'entrefer principal 52. L'entrefer secondaire 59 est plus large (la largeur étant comptée dans le sens de déplacement relatif du support 70) que l'entrefer principal 52.

Dans le cas de la figure 10, un bobinage conducteur 58 peut être enroulé autour de la branche de fermeture 56.

La figure 11 illustre encore une autre variante où le capteur ne comprend que deux pièces polaires 50-1, 50-2 et deux branches latérales 54-1, 54-2, ces dernières ayant des bords intérieurs définissant l'entrefer secondaire 61.

Enfin, la figure 12 montre un capteur du type comprenant une MR encadrée par deux écrans magnétiques. Selon l'invention, ces écrans 71-1, 71-2 ont une forme évasée et la MR 72 est placée entre ces écrans.

Quel que soit le mode de réalisation, la magnétorésistance peut être placée dans l'entrefer secondaire, ou sur ou sous cet entrefer.

La magnétorésistance peut travailler soit en mode transverse, soit en mode longitudinal. Elle peut aussi travailler sur certaines parties en mode longitudinal et sur d'autres parties en mode transversale. C'est le cas pour les variantes illustrées où la magnétorésistance présence une forme en grecque. La MR peut aussi avoir une forme parallélèpipédique (mode transverse).

La magnétorésistance peut être constituée d'une couche unique ou d'une multicouche à effet géant.

## Revendications

1. Capteur de champ magnétique comprenant un circuit magnétique (12-1, 12-2, 16-1, 16-2, 28-1, 28-2), (50-1, 50-2, 54-1, 54-2, 56-1, 56-2), (20-1, 20-2, 28-1, 28-2) avec un entrefer principal (30, 52) apte à être traversé par le champ à capter, ce circuit magnétique étant interrompu par au moins un entrefer secondaire (15, 57, 22, 53) pourvu d'une magnétorésistance (25, 55, 72), ce capteur étant **caractérisé en ce que** le circuit magnétique présente une forme évasée de part et d'autre de l'entrefer secondaire (15, 22, 57, 59, 61) en s'élargissant au niveau dudit entrefer secondaire.

2. Capteur selon la revendication 1, présentant une structure de tête magnétique horizontale avec un circuit magnétique comprenant au moins une couche magnétique avant avec deux pièces polaires (28-1, 28-2) séparées par l'entrefer principal (30) et une couche magnétique arrière (12-1, 12-2) couplée à la couche magnétique avant, ces couches magnétiques avant et arrière étant disposées dans des plans parallèles, la tête étant destinée à coopérer avec un support d'enregistrement magnétique (40) disposé parallèlement à ces plans.

3. Capteur selon la revendication 2, dans lequel la couche magnétique avant (28-1, 28-2) et la couche magnétique arrière (12-1, 12-2) sont réunies par deux piliers magnétiques (16-1, 16-2).

4. Capteur selon l'une quelconque des revendications 2 et 3, dans lequel l'entrefer secondaire (15) interrompant le circuit magnétique est disposé dans la couche magnétique arrière, celle-ci présentant deux parties évasées (12-1, 12-2) de part et d'autre de l'entrefer secondaire (15).

5. Capteur selon la revendication 3, dans lequel le circuit magnétique comprend en outre deux couches magnétiques intermédiaires (20-1, 20-2) disposées entre la couche magnétique avant (28-1, 28-2) et la couche magnétique arrière (12), ces deux couches magnétiques intermédiaires étant en contact avec les piliers magnétiques (16-1, 16-2) et étant séparées l'une de l'autre par ledit entrefer secondaire (22), ces deux couches magnétiques intermédiaires (20-1, 20-2) présentant des parties évasées de part et d'autre de l'entrefer secondaire (22).

6. Capteur selon l'une quelconque des revendications 2 à 5, dans lequel le circuit magnétique est pourvu d'un bobinage conducteur (19).

7. Capteur selon la revendication 2, dans lequel le circuit magnétique ne comprend qu'une couche avant magnétique (28-1, 28-2) avec l'entrefer principal (30) et qu'une couche magnétique arrière (20-1, 20-2) interrompue par l'entrefer secondaire (22)

8. Capteur selon la revendication 1, présentant une structure de tête magnétique verticale, le circuit magnétique comprenant une couche magnétique (50-1, 50-2, 54-1, 54-2, 56-1, 56-2) disposée dans un plan, la tête étant destinée à coopérer avec un support d'enregistrement magnétique (70) perpendiculaire à ce plan.

9. Capteur selon la revendication 8, dans lequel le circuit magnétique comprend deux pièces polaires (50-1, 50-2) séparées par l'entrefer principal (52), deux branches latérales (54-1, 54-2) et une branche arrière (56-1, 56-2) de fermeture du circuit.

10. Capteur selon la revendication 9, dans lequel l'entrefer secondaire (57) interrompant le circuit magnétique est disposé dans la branche arrière de fermeture du circuit, cette branche comprenant deux parties évasées (56-1, 56-2) de part et d'autre de l'entrefer secondaire (57).

11. Capteur selon la revendication 9, dans lequel l'entrefer secondaire interrompant le circuit magnétique est disposé dans une des bandes latérales (54-1, 54-2).

12. Capteur selon la revendication 9, dans lequel les branches latérales (54-1, 54-2) présentent deux parties évasées (51-1, 51-2) en regard l'une de l'autre, l'entrefer secondaire (61) étant disposé entre ces parties évasées (51-1, 51-2) et placé derrière l'entrefer principal (52).

13. Capteur selon la revendication 12, dans lequel l'entrefer secondaire (59) est plus large que l'entrefer principal (52).

14. Capteur selon l'une des revendications 8 à 13, dans lequel le circuit magnétique (56) est pourvu d'au moins un enroulement conducteur (58).

15. Capteur selon la revendication 8, dans lequel le circuit magnétique ne comprend que les deux pièces polaires (50-1, 50-2) séparées par l'entrefer principal (52) et deux branches latérales (54-1, 54-2), ces deux branches latérales étant séparées l'une de l'autre par ledit entrefer secondaire (61).

16. Capteur selon la revendication 1, dans lequel l'entrefer principal et l'entrefer secondaire sont confondus.

17. Capteur selon l'une quelconque des revendications 1 à 16, dans lequel la magnétorésistance (25, 55, 72) est placée dans l'entrefer secondaire (15, 22, 57, 59, 61).

18. Capteur selon l'une quelconque des revendications 1 à 16, dans lequel la magnétorésistance (25, 55, 72) est placée au-dessus ou au-dessous de l'entrefer secondaire (15, 22, 57, 59, 61).

19. Capteur selon l'une quelconque des revendications 1 à 18, dans lequel la magnétorésistance (25, 55, 72) travaille en mode transverse.

20. Capteur selon l'une quelconque des revendications 1 à 18, dans lequel la magnétorésistance (25, 55, 72) travaille en mode longitudinal.

21. Capteur selon l'une quelconque des revendications 1 à 18, dans lequel la magnétorésistance (25, 55, 72) travaille sur certaines parties en mode transverse et sur certaines autres parties en mode longitudinal.

22. Capteur selon la revendication 21, dans lequel la magnétorésistance (25, 55, 72) présente une forme en grecque.

23. Capteur selon la revendication 1, comprenant une magnétorésistance (72) encadrée par deux écrans magnétiques (71-1, 71-2) présentant une forme évasée.

## Patentansprüche

1. Magnetfeldfühler, einen Magnetkreis (12-1, 12-2, 16-1, 16-2, 28-1, 28-2), (50-1, 50-2, 54-1, 54-2, 56-1, 56-2), (20-1, 20-2, 28-1, 28-2) mit einem Hauptspalt (30, 52) umfassend, den das zu fühlende bzw. zu detektierende Magnetfeld durchqueren kann, wobei dieser Magnetkreis durch wenigstens einen Sekundärspalt (15, 57, 22, 53) unterbrochen wird, der mit einem Magnetowiderstand (25, 55, 72) versehen ist, und dieser Fühler dabei
**dadurch gekennzeichnet** ist, dass der Magnetkreis eine ausweitete Form beiderseits des Sekundärspalte (15, 22, 57, 59, 61) aufweist, indem er sich in Höhe des genannten Sekundärspalts verbreitert.

2. Fühler nach Anspruch 1, die Struktur eines horizontalen Magnetkopfs mit einem Magnetkreis aufweisend, der wenigstens eine Magnetschicht mit zwei durch den Hauptspalt (30) getrennten Polschuhen (28-1, 28-2) und eine hintere Magnetschicht (12-1, 12-2) umfasst, die mit der vorderen Magnetschicht gekoppelt ist, wobei diese vordere und hintere Magnetschicht in parallelen Ebenen angeordnet sind und der Kopf dazu bestimmt ist, mit einem magnetischen Aufzeichnungsträger (40) zusammenzuwirken, der parallel zu diesen Ebenen angeordnet ist.

3. Fühler nach Anspruch 2, bei dem die vordere Magnetschicht (28-1, 28-2) und die hintere Magnetschicht (12-1, 12-2) durch zwei magnetische Elemente (16-1, 16-2) verbunden sind.

4. Fühler nach einem der Ansprüche 2 und 3, bei dem der den Magnetkreis unterbrechende Sekundärspalt (15) sich in der hinteren Magnetschicht befindet, wobei diese zwei ausgeweitete Teile (12-1, 12-2) beiderseits des Sekundärspalts (15) aufweist.

5. Fühler nach Anspruch 3, bei dem der Magnetkreis außerdem zwei magnetische Zwischenschichten (20-1, 20-2) aufweist, angeordnet zwischen der vorderen Magnetschicht (28-1, 28-2) und der hinteren Magnetschicht (12), wobei diese beiden magnetischen Zwischenschichten mit den magnetischen Elementen (16-1, 16-2) in Kontakt sind und durch den genannten Sekundärspalt (22) voneinander getrennt sind, und diese beiden magnetischen Zwischenschichten (20-1, 20-2) ausgeweitete Teile beiderseits des Sekundärspalts (22) aufweisen.

6. Fühler nach einem der Ansprüche 2 bis 5, bei dem der Magnetkreis mit einer leitenden Spule (19) verbunden ist.

7. Fühler nach Anspruch 2, bei dem der Magnetkreis nur eine vordere Magnetschicht (28-1, 28-2) mit dem Hauptspalt (30) und nur eine durch den Sekundärspalt (22) unterbrochene hintere Magnetschicht (20-1, 20-2) umfasst.

8. Fühler nach Anspruch 1 mit einer Struktur eines vertikalen Magnetkopfs, wobei der Magnetkreis eine in einer Ebene angeordnete Magnetschicht (50-1, 50-2, 54-1, 54-2, 56-1, 56-2) umfasst und der Kopf dazu bestimmt ist, mit einem zu dieser Ebene senkrechten magnetischen Aufzeichnungsträger (70) verbunden zu werden.

9. Fühler nach Anspruch 8, bei dem der Magnetkreis zwei durch den Hauptspalt (52) getrennte Polschuhe (50-1, 50-2), zwei seitliche Zweig (54-1, 54-2) und einen den Kreis schließenden hinteren Zweig (56-1, 56-2) umfasst.

10. Fühler nach Anspruch 9, bei dem der den Magnetkreis unterbrechende Sekundärspalt (57) in dem hinteren, den Kreis schließenden Zweig vorgesehen ist, wobei dieser Zweig zwei ausgeweitete Teile (56-1, 56-2) beiderseits des Sekundärspalts (57) umfasst.

11. Fühler nach Anspruch 9, bei dem der den Magnetkreis unterbrechende Sekundärspalt in einem der seitlichen Zweige (54-1, 54-2) vorgesehen ist.

12. Fühler nach Anspruch 9, bei dem die seitlichen Zweige (54-1, 54-2) zwei sich gegenüberstehende ausgeweitete Teile (51-1, 51-2) aufweisen und der Sekundärspalt (61) zwischen diesen ausgeweiteten Teilen (51-1, 51-2) vorgesehen und hinter dem Hauptspalt (52) angeordnet ist.

13. Fühler nach Anspruch 12, bei der Sekundärspalt (59) breiter ist als der Hauptspalt (52).

14. Fühler nach einem der Ansprüche 8 bis 13, bei dem der Magnetkreis (56) mit wenigstens einer leitenden Wicklung (58) versehen ist.

15. Fühler nach Anspruch 8, bei dem der Magnetkreis nur die beiden durch den Hauptspalt (52) getrennten Polstücke (50-1, 50-2) und zwei seitliche Zweige (54-1, 54-2) umfasst, wobei diese beiden seitlichen Zweige durch den genannten Sekundärspalt (61) voneinander getrennt sind.

16. Fühler nach Anspruch 1, bei dem der Hauptspalt und der Sekundärspalt zusammenfallen.

17. Fühler nach einem der Ansprüche 1 bis 16, bei dem der Magnetowiderstand (25, 55, 72) in dem Sekundärspalt (15, 22, 57, 59, 61) angeordnet ist.

18. Fühler nach einem der Ansprüche 1 bis 16, bei dem der Magnetowiderstand (25, 55, 72) über oder unter dem Sekundärspalt (15, 22, 57, 59, 61) angeordnet ist.

19. Fühler nach einem der Ansprüche 1 bis 18, bei dem der Magnetowiderstand (25, 55, 72) im Transversalbetrieb arbeitet.

20. Fühler nach einem der Ansprüche 1 bis 18, bei dem der Magnetowiderstand (25, 55, 72) im Longitudinalbetrieb arbeitet.

21. Fühler nach einem der Ansprüche 1 bis 18, bei dem der Magnetowiderstand (25, 55, 72) in bestimmten Teilen im Transversalbetrieb arbeitet und in anderen bestimmten Teilen im Longitudinalbetrieb.

22. Fühler nach Anspruch 21, bei dem der Magnetowiderstand (25, 55, 72) eine Mäanderform aufweist.

23. Fühler nach Anspruch 1 mit einem Magnetowiderstand (72), umrahmt bzw. eingeschlossen durch zwei magnetische Schirme (71-1, 71-2), die eine sich konisch erweiternde Form aufweisen.

## Claims

1. Magnetic field sensor comprising a magnetic circuit (12-1, 12-2, 16-1, 16-2, 28-1, 28-2), (50-1, 50-2, 54-1, 54-2, 56-1, 56-2), (20-1, 20-2, 28-1, 28-2) with a main air gap (30, 52) through which a field to be detected can pass, this magnetic circuit being interrupted by at least one secondary air gap (15, 57, 22, 53) provided with a magnetoresistance (25, 55, 72), this sensor being **characterized in that** the magnetic circuit has a hollowed out shape on each side of the secondary air gap (15, 22, 57, 59, 61) widening level with said secondary air gap.

2. Sensor according to claim 1, with a horizontal magnetic head structure with a magnetic circuit comprising at least one magnetic layer with two polar parts (28-1, 28-2) separated by the main air gap (30) and a rear magnetic layer (12-1, 12-2) coupled to the front magnetic layer, these front and rear magnetic layers being located in parallel planes, the head being designed to cooperate with a magnetic recording support (40) placed parallel to these planes.

3. Sensor according to claim 2, in which the front magnetic layer (28-1, 28-2) and the rear magnetic layer (12-1, 12-2) are connected through two magnetic pillars (16-1, 16-2).

4. Sensor according to any one of claims 2 and 3, in which the secondary air gap (15) interrupting the magnetic circuit is placed in the rear magnetic layer, which has two hollowed out parts (12-1, 12-2) on each side of the secondary air gap (15).

5. Sensor according to claim 3, in which the magnetic circuit also comprises two intermediate magnetic layers (20-1, 20-2) placed between the front magnetic layer (28-1, 28-2) and the rear magnetic layer (12), these two intermediate magnetic layers being in contact with magnetic pillars (16-1, 16-2) and being separated from each other by the said secondary air gap (22), these two intermediate magnetic layers (20-1, 20-2) having hollowed out parts on each side of the secondary air gap (22).

6. Sensor according to any one of claims 2 to 5, in which the magnetic circuit is provided with a conducting coil (19).

7. Sensor according to claim 2, in which the magnetic circuit comprises only one front magnetic layer (28-1, 28-2) with the main air gap (30) and only one rear magnetic layer (20-1, 20-2) interrupted by the secondary air gap (22).

8. Sensor according to claim 1, with a vertical magnetic head structure, the magnetic circuit comprising a magnetic layer (50-1, 50-2, 54-1, 54-2, 56-1, 56-2) located in a plane, the head being designed to cooperate with a magnetic recording support (70) perpendicular to this plane.

9. Sensor according to claim 8, in which the magnetic circuit comprises two polar parts (50-1, 50-2) separated by the main air gap (52), two side arms (54-1, 54-2) and a rear circuit closing arm (56-1, 5-2).

10. Sensor according to claim 9, in which the secondary air gap (57) interrupting the magnetic circuit is laid out in the rear circuit closing arm, this arm comprising two hollowed out parts (56-1, 56-2) on each side of the secondary air gap (57).

11. Sensor according to claim 9, in which the secondary air gap interrupting the magnetic circuit is placed in one of the side arms (54-1, 54-2).

12. Sensor according to claim 9, in which the side arms (54-1, 54-2) with two hollowed out parts (51-1, 51-2) facing each other, the secondary air gap (61) being located between these hollowed out parts (51-1, 51-2) and placed behind the main air gap (52).

13. Sensor according to claim 12, in which the secondary air gap (59) is wider than the main air gap (52).

14. Sensor according to any one of claims 8 to 13, in which the magnetic circuit (56) is provided with at least one conducting coil (58).

15. Sensor according to claim 8, in which the magnetic circuit only comprises two polar parts (50-1, 50-2) separated by the main air gap (52) and two side arms (54-1, 54-2), these two side arms being separated from each other by the said secondary air gap (61).

16. Sensor according to claim 1, in which the main air gap and the secondary air gap are coincident.

17. Sensor according to any one of claims 1 to 16, in which the magnetoresistance (25, 55, 72) is located in the secondary air gap (15, 22, 57, 59, 61).

18. Sensor according to any one of claims 1 to 16, in which the magnetoresistance (25, 55, 72) is placed above or below the secondary air gap (15, 22, 57, 59, 61).

19. Sensor according to any one of claim 1 to 18, in which the magnetoresistance (25, 55, 72) works in transverse mode.

20. Sensor according to any one of claims 1 to 18, in which the magnetoresistance (25, 55, 72) works in longitudinal mode.

21. Sensor according to any one of claims 1 to 18, in which the magnetoresistance (25, 55, 72) works on some parts in transverse mode and on other parts in longitudinal mode.

22. Sensor according to claim 21, in which the magnetoresistance (25, 55, 72) is in the form of an orthogonal pattern of straight lines.

23. Sensor according to claim 1, comprising a magnetoresistance (72) surrounded by two magnetic screens (17-1, 17-2) with a hollowed out shape.
